# EUROPEAN PATENT APPLICATION

(11) **EP 4 770 302 A1**
(43) Date of publication of application: **01.07.2026**
(21) Application number: 24223647.9
(22) Date of filing: 30.12.2024
(51) Int. Cl.: H10B 12/00, H10D 1/68, H10D 30/67

(54) **A SEMICONDUCTOR STRUCTURE FOR A 3D DRAM WITH A 1T1C MEMORY CELL CONFIGURATION**

(71) Applicant: IMEC VZW, 3001 Leuven (BE)
(72) Inventor: Rassoul, Nouredine, 1440 Braine le Chateau (BE); Kar, Gouri Sankar, 3001 Leuven (BE)
(74) Representative: Roth, Sebastian

(57) **Abstract**

The present disclosure relates to a semiconductor structure for a 3D DRAM comprising one 1T1C memory cell architecture and vertical bit lines. The semiconductor structure comprises a stack of semiconductor layers and dielectric layers alternatingly arranged along a first axis. Further, a first and second pillar of memory cells arranged displaced along a second axis and extending along the first axis through the stack. Each memory cell comprises a part of one of the semiconductor layers, and one transistor structure and one capacitor with a semiconductor channel and a metal gate that at least partly surrounds the semiconductor channel. The metal gates of memory cells in the same pillar are isolated from each other, and metal gates of memory cells that comprise parts of the same semiconductor layer form an integral metal structure.

## Description

### TECHNICAL FIELD

The present disclosure relates to dynamic random access memory (DRAM), in particular, is concerned with three-dimensional (3D) DRAM, which is a DRAM with a 3D array of memory cells. The disclosure provides a semiconductor structure for such a 3D DRAM, the semiconductor structure comprising one transistor (1T) and one capacitor (1C) per memory cell, and vertical bit lines.

### BACKGROUND

The relentless demand for increased DRAM capacity across various fields, including artificial intelligence (AI), the Internet of Things (IoT), data centers, and cloud computing, drives the search for alternative DRAM concepts. One promising approach is capacitor-less DRAM, which attracts significant interest, because the storage capacitor currently restricts the scalability of DRAM memory cells.

Another approach is to integrate 1T1C memory cells into a 3D DRAM architecture, as this approach could address scalability challenges and significantly enhance memory density.

However, several challenges often accompany improvements in DRAM density and scalability. For instance, the limitations in DRAM density are closely tied to the patterning techniques employed during fabrication. Additional constraints arise from the memory design itself. Furthermore, current processing technologies for 1T1C DRAM are laid out for 2D systems, rather than 3D configurations. As a result, enhancements in memory density are primarily restricted to two dimensions. Moreover, the fabrication of 3D DRAM configurations involves highly intricate and expensive processes.

### SUMMARY

In view of the above, this disclosure has the objective to provide a semiconductor structure for enabling a new approach for a 3D DRAM. The above-mentioned challenges should be addressed. A particular objective is to provide a 1T1C memory cell array in 3D. An objective thereby is to enable a well-scalable concept that achieves a significant increase in memory density. Another objective is to provide a process for fabricating such a semiconductor structure for a 3D DRAM, wherein the process should be of low complexity and not expensive.

These and other objectives are achieved by the solutions of this disclosure, which are described in the independent claims. Advantageous implementations are described in the dependent claims.

A first aspect of this disclosure provides a semiconductor structure for a 3D memory, the semiconductor structure comprising: a stack comprising a plurality of semiconductor layers and dielectric layers, which are alternatingly arranged on another along a first axis; a first pillar of memory cells and a second pillar of memory cells, wherein the first and second pillar are arranged displaced to each other along a second axis, which is perpendicular to the first axis, and respectively extend along the first axis through the layers of the stack; wherein each memory cell of the first and the second pillar comprises a part of one of the semiconductor layers; wherein each memory cell of the first and the second pillar comprises one transistor structure and one capacitor structure; wherein each transistor structure comprises a semiconductor channel and a metal gate that at least partly surrounds the semiconductor channel; wherein the metal gates of memory cells in the same pillar are isolated from each other; and wherein the metal gates of memory cells of the first and second pillar that comprise parts of the same semiconductor layer form an integral metal structure.

The semiconductor structure of the first aspect has 1T1C memory cells, which are arranged in a 3D memory cell array. The semiconductor structure of the first aspect thus enables a 1T1C 3D DRAM, which achieves a significant increase in memory density and is scalable.

The use of the integral metal structures allows realizing word lines, and makes the 3D DRAM concept of this disclosure well scalable. In particular, each of the integral metal structures allows controlling at least the two memory cells of the two different pillars, with which they are associated. Namely, the integral metal structures may, like word lines in a conventional DRAM, control the respective transistor structures of these memory cells, e.g., may turn on the respective transistor structure. In each memory cell, the transistor structure may act as an access transistor to the capacitor structure, and the capacitor structure may act as storage capacitor. Each integral metal structure enables the writing of charge into the capacitor structure, or the reading of charge stored in the capacitor structure. Each integral metal structure may be activated by a respective word line signal.

The semiconductor structure may comprise more pillars than the first and second pillar, as will be explained in more detail below. Additional pillars may be arranged in direction of the second axis, but also in direction of a third axis perpendicular to the first and second axis. This allows realizing the 3D array of memory cells. In this case, each integral metal structure may control more than two memory cells of more than two pillars. Each integral metal structure, however, may control only one memory cell per pillar.

The multiple semiconductor layers of the stack may define multiple planes, which are stacked along the first axis (separated by dielectric material). If there are multiple pillars arranged along the second axis and along the third axis, each plane comprises a 2D array of memory cells, i.e., memory cells of different pillars but all comprising parts of the same semiconductor layer (of that plane). Each of these 2D arrays may have its memory cells organized in rows (e.g., extending along the second axis) and columns (extending along the third axis). The arrangement of the pillars along the second and third axis may be accordingly.

In an implementation of the semiconductor structure, each integral metal structure is a word line and/or is connected to at least one word line driver.

The integral metal structures may respectively control, as the word lines, the multiple memory cells they are associated with, by applying respective word line signals, for instance, generated by the word line drivers. The multiple memory cells, which are controlled per integral metal structure, are all on the same level/plane regarding the "third dimension" along the first axis.

In an implementation of the semiconductor structure, in each memory cell, the transistor structure and the capacitor structure are formed next to each other along the third axis.

With this compact memory cell design, an overall compact semiconductor structure can be achieved, and the placing of bit lines and plate lines into the memory array is facilitated.

In an implementation of the semiconductor structure, the semiconductor structure further comprises a plurality of bit lines; wherein each bit line extends along the first axis and is connected to all the memory cells of one pillar.

The semiconductor structure of the first aspect thus comprises so-called vertical bit lines, as they extend along the first axis, which is considered the vertical axis in this disclosure. The second and third axis may be horizontal axis, and the three axis may span a coordinate system. Vertical bit lines may have the advantage, that connection of the bit lines to global bit lines is facilitated, which may reduce the area consumption of the 3D DRAM, e.g., due to a more relaxed placement and routing of the sense amplifiers. Additionally, a parasitic bit line loading can be reduced.

In an implementation of the semiconductor structure, the semiconductor structure further comprises: one or more additional pillars of memory cells arranged one after the other along the second axis and in-line with the first and second pillar and respectively extending through the layers of the stack; wherein the integral metal structures are stacked along the first axis, and each integral metal structure is associated with two or more of the pillars arranged along the second axis.

In this case, the integral metal structures may control transistor structures of more than two memory cells (in the same plane).

In an implementation of the semiconductor structure, each integral metal structure is associated with more pillars than the integral metal structure arranged above it.

In an implementation of the semiconductor structure, the integral metal structures are stacked in a staircase arrangement.

The staircase arrangement, which is achieved by the above implementations, facilitates the contacting of the integral metal structures, for instance, to provide the respective word line signals. For example, the integral metal structures can be contacted from above, particularly in a vertical manner. For example, contact vias can be provided, which may extend through the semiconductor structure to land on the respective (top) surfaces of the integral metal structures forming the staircase structure.

In an implementation of the semiconductor structure, the semiconductor structure further comprises: a third pillar of memory cells and a fourth pillar of memory cells; wherein the third and fourth pillar are arranged displaced to each other along the second axis, respectively extend through the layers of the stack, and are respectively arranged displaced from the first and second pillar along a third axis, which is perpendicular to the first and second axis; wherein each memory cell of the third and fourth pillar comprises one of the semiconductor layers; wherein each memory cell of the third and fourth pillar comprises one transistor structure and one capacitor structure; and wherein the metal gates of the memory cells of the third and fourth pillar that comprise parts of the same semiconductor layer form a second integral metal structure, which is isolated from the integral metal structure formed by the metal gates of the memory cells of the first and second pillar that comprise parts of the same semiconductor layer.

The integral metal structures which are associated with the third and fourth pillar may run in parallel to the integral metal structures which associated with the first and second pillar.

In an implementation of the semiconductor structure, a shape of the stack of semiconductor layers and dielectric layers, when viewed from above along the first axis, comprises a principal axis and symmetrically or asymmetrically attached elements extending away from the principal axis on both sides of the principal axis; wherein the pillars of memory cells are formed at least partly in the attached elements.

Throughout this disclosure the terms "below" and "above", "bottom" and "top", "front", "frontside", "back" and "backside", or similar terms, are to be interpreted relative to each other. In particular, these terms describe opposite sides of the semiconductor structure, or opposite sides of any element of the semiconductor structure. The terms may describe a relationship of elements (e.g., layers, the stack, memory cells, transistor structures, capacitor structures, etc.) or a relative contacting of one element to the other, in the semiconductor structure. The terms particularly relate to the first axis, which corresponds to the stacking direction of the layers of the stack. That is, if an element is arranged "above" or "below" another element, this means that the two elements are displaced with respect to each other along the first axis.

This particular shape (referred to as a grid in this disclosure) facilitates the fabrication process, as will be explained below. The shape may especially facilitate a separation of the semiconductor layers between adjacent pillars, which are associated with the same integral metal structure.

A second aspect of this disclosure provides a method of fabricating a semiconductor structure for 3D DRAM, the method comprising: forming a stack comprising a plurality of semiconductor layers and dielectric layers, which are alternatingly arranged on another along a first axis; forming a first pillar of memory cells and a second pillar of memory cells, wherein the first and second pillar are formed displaced to each other along a second axis, which is perpendicular to the first axis, and respectively extend along the first axis through the layers of the stack; wherein each memory cell is formed from a part of one of the semiconductor layers; wherein for each memory cell one transistor structure and one capacitor structure is formed; wherein each transistor structure comprises a semiconductor channel and a metal gate that is formed to at least partly surround the semiconductor channel; wherein the metal gates of memory cells in the same pillar are isolated from each other; and wherein the metal gates of memory cells of the first and second pillar that are formed from parts of the same semiconductor layer are formed as an integral metal structure.

Notably, this describes general method steps to produce the semiconductor structure, wherein these steps do not necessarily have to be performed in the given order. For instance, as will become clear in the following, the pillars of memory cells can be formed before the dielectric layers are formed (which may initially be dummy layers, and are later replaced by dielectric layers).

In an implementation of the method, the method further comprises: forming a third pillar of memory cells and a fourth pillar of memory cells; wherein the third and fourth pillar are formed displaced to each other along the second axis, respectively extend along the first axis through the layers of the stack, and are respectively formed offset from the first and second pillar along a third axis, which is perpendicular to the first and second axis; wherein each memory cell of the third and fourth pillar is formed from a part of one of the semiconductor layers; wherein each memory cell of the third and fourth pillar comprises one transistor structure and one capacitor structure; wherein the metal gates of memory cells of the third and fourth pillar that are formed from parts of the same semiconductor layer are formed by a second integral metal structure, which is isolated from the integral metal structure formed by the metal gates of memory cells of the first and second pillar that are formed form parts of the same semiconductor layer.

In an implementation of the method, for forming the stack and the pillars of memory cells in the stack, the method comprises: growing and/or depositing a stack comprising a plurality of semiconductor layers and dummy layers, which are alternatingly arranged on another along the first axis, wherein the semiconductor layers are respectively thicker than the dummy layers; forming a cavity for each memory pillar, each cavity extending along the first axis through the layers of the stack; removing the dummy layers; and forming the memory cells from the semiconductor layers through the cavities.

The dummy layers may be silicon germanium layers. The dummy layers may also be made of amorphous silicon, or silicon oxide, or silicon nitride, or a metal oxide. The places where the dummy layers have been removed may, after they form the memory cells, be filled with the dielectric layers.

In an implementation of the method, after forming the cavities and before removing the dummy layers, the method further comprises shaping the stack of semiconductor layers and dummy layers, when viewed from above along the first axis, into a shape comprising a principal axis and symmetrically or asymmetrically attached elements extending away from the principal axis on both sides of the principal axis; and wherein the cavities are formed in the attached elements.

In an implementation of the method, after removing the dummy layers and before forming the memory cells, the method further comprises separating the principal axis of the shape of the stack between a pair of the attached elements, wherein the separating optionally includes thinning the semiconductor layers; depositing gate dielectric to surround each semiconductor channel; and forming the metal gates by direct material deposition or material replacement.

The shape and the separation of the principal axis thereof ensures that the semiconductor layer is separated (into multiple parts) between adjacent pillars, which are associated with the same integral metal structures. Thus, the channels of the transistor structures of the respective memory cells can be separated and individually controlled. The attached elements may have a rectangular shape from a design, but maybe non-rectangular after processing the semiconductor structure. For instance, they may be rectangular-like, but with rounded corners after the processing. The step of separating may be performed in combination or not with the thinning of the initial semiconductor layer as deposited. For instance, thinning of silicon layers, as an example of the semiconductor layers, may be performed. The method of the second aspect may have further implementations that correspond to the implementations of the device of the first aspect. The method of the second aspect achieves the effects and advantages described above with respect to the device of the first aspect and its implementations.

In summary, the present disclosure provides a semiconductor structure and a fabrication method of such a semiconductor structure, which takes the advantage of the third dimension to enable 1T1C memory cells in a 3D DRAM. This releases the pressure of using complex processes focused only on two dimensions, and also enables a highly scalable and high density 3D DRAM.

### BRIEF DESCRIPTION OF THE DRAWINGS

The above described aspects and implementations are explained in the following description of exemplary embodiments with respect to the enclosed drawings, wherein:
- FIG. 1: shows an exemplary semiconductor structure according to this disclosure.
- FIG. 2: shows exemplary circuit schematics of a semiconductor structure according to this disclosure.
- FIG. 3-18: shows exemplary steps of processing a semiconductor structure according to this disclosure.
- FIG. 19: shows a flow-diagram of a method for processing a semiconductor structure according to this disclosure.

In the drawings and figures, same elements of the semiconductor structure or method are labeled with the same reference signs and may be implemented likewise.

### DETAILED DESCRIPTION OF EMBODIMENTS

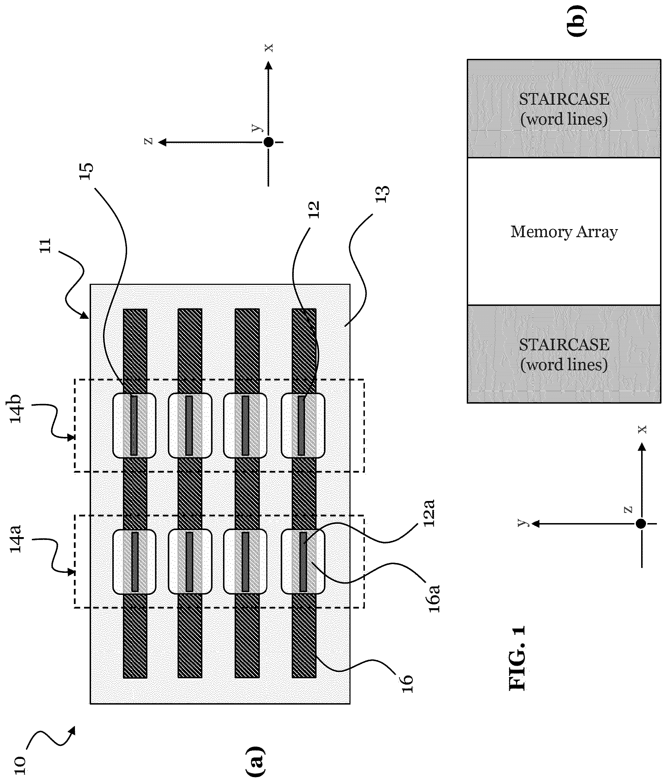

FIG. 1(a) shows a semiconductor structure 10 according to this disclosure. The semiconductor structure 10 is suitable for 3D DRAM, for instance, the semiconductor structure 10 can be used to build a 3D DRAM. Thereby, a 3D DRAM is a DRAM that comprises a 3D array of memory cells 15. In FIG. 1, memory cells are shown only schematically and arranged along the z-axis (vertical axis) and the x-axis (horizontal axis), respectively. However, more memory cells 15 may also be arranged along the y-axis (i.e., in direction into the plane of FIG. 1(a)).

The semiconductor structure 10 comprises (when processed completely) a plurality of semiconductor layers 12 and dielectric layers 13, which are alternatingly arranged on another along a first axis (the z-axis). The semiconductor layers 12 may, for example, be silicon layers, but also other semiconductor material systems like III-V, or metal oxide, or 2D material, are possible. The dielectric layers 13 may be oxide layers, for example, silicon oxide layers and/or silicon nitride layers.

The semiconductor structure 10 further comprises a first pillar 14a of memory cells 15 and a second pillar 14b of memory cells 15. The first pillar 14a and the second pillar 14b are arranged displaced to each other along a second axis (the x-axis), which is perpendicular to the first axis (the z-axis). Each pillar 14a, 14b (generally pillar 14) extends along the first axis through the layers of the stack 11, in the sense that the memory cells 15 of that pillar are arranged one after the other along the first axis. Notably, the pillars are not necessarily an entirely integral structure, but is formed primarily by the plurality of stacked memory cells 15. Such a construct is enough to be referred to as a pillar 14 in this disclosure. The memory cells 15 of the same pillar 14 may share a bit line, as explained later.

Each memory cell 15 of the first and the second pillar 14a, 14b comprises a part of one of the semiconductor layers 12. Generally, each pillar 14 of the semiconductor structure 10 may have as many memory cells 15 as there are semiconductor layers 12 it extends through. That is, the number of semiconductor layers 12 of the stack 11 may define the number of memory cells 15 per pillar 14 (along the z-axis). The number of pillars 14 that are formed along the x-axis, and the number of pillars 14 that are formed along the y-axis, may define the number of memory cells 15 per semiconductor layer 12.

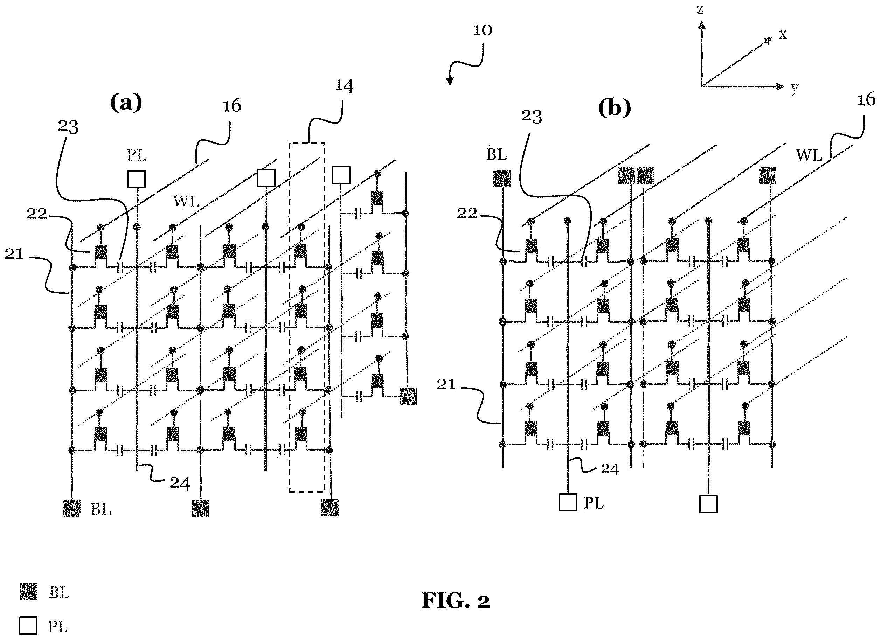

Further, each memory cell 15 of the first and the second pillar 14a, 14b comprises one transistor structure 22 and one capacitor structure 23 (not shown in FIG. 1, but for example shown in FIG. 2). Accordingly, each memory cell 15 is a 1T1C cell, and this may lead to a 1T1C 3D DRAM in the end. Each transistor structure 22 comprises a semiconductor channel (which is made from and/or in one of the semiconductor layers 12), and a metal gate that at least partly surrounds the semiconductor channel. The metal gates of memory cells 15 in the same pillar are isolated from each other. The metal gates of memory cells 15 of the first and second pillar 14a, 14b, which comprise parts of the same semiconductor layer 12, form an integral metal structure 16. Therefore, the integral metal structures 16 respectively extend along the second axis. Each integral metal structure 16 thereby extends in one of multiple stacked planes, which are defined respectively by the multiple semiconductor layers 12. Each integral metal structure 16 forms the metal gates of multiple transistor structures 22 of multiple memory cells 15.

The integral metal structures 16 may be or be used as word lines, i.e., horizontal word lines. Notably, there may be more than two pillars 14 of memory cells arranged one after the other and displaced along the second axis. If there are more than two such pillars 14, the integral metal structures 16 become longer in the x-direction. However, as shown later, not all of the integral metal structures may have the same length in this case. That is, some integral metal structures 16 may be associated with more pillars 14 than others. This may lead to a staircase structure of the integral metal structures 16.

As shown in FIG. 1(b) in a top view, the semiconductor structure 10 may comprise a memory array region, and a region, where the staircase structure can be contacted from the top and/or the bottom of the semiconductor structure 10.

Further, there may also be pillars 14 arranged behind the pillars 14a and 14b shown in FIG. 1(a), i.e., displaced along the y-axis. For example, a third pillar 14 of memory cells and a fourth pillar 14 of memory cells 15, wherein the third and fourth pillar 14 are arranged displaced to each other along the second axis, and are respectively arranged displaced from the first and second pillar along a third axis (the y-axis). Also the third and fourth pillars 14 extend through the layers of the stack 11.

In the semiconductor structure 10, word lines (i.e. the integral metal structures 16) respectively extend along the x-axis (they are thus referred to as horizontal word lines) as shown in FIG. 1, and are arranged along the z-axis (stacked and isolated), as also shown in FIG. 1. Additional word lines, which likewise extend respectively along the x-axis, may be located displaced along y-axis (e.g. stacked and isolated) which is not shown in FIG. 1.

FIG. 2 shows exemplary circuit schematics for the memory cells 15 of the semiconductor structure 10 and resulting 3D DRAM, in particular, connections to the word lines (WL) (implemented by the integral metal structures 16), to the bit lines (BL) 21, and to plate lines (PL) 24. FIG. 2 shows the circuit schematics along all three axis.

As mentioned before, the word lines 16 respectively extend along the x-axis. The bit lines 21 respectively extend along the z-axis, in parallel to the stacking direction of the memory cells 15 of each of the pillars 14. The bit lines 21 are thus referred to as vertical bit lines. Each bit line 21 is connected to one memory cell 15 in each plane (defined by the semiconductor layers 12). That is, each bit line 21 is connected to a pillar 14 (one pillar 14 is exemplarily highlighted by the dotted rectangle) of memory cells 15. Each bit line 21 is particularly connected to a respective source/drain of the transistor structures 21 of one pillar 14. The plate lines 24 may also extend along the z-axis. Each plate line 24 is connected to the plates of multiple capacitor structures 23. The plate lines 24 can all be merged together by additional metal vias and line routing. Notably, the plate lines 24 may be connected to the capacitor structures 23 to help maintain charge, while the bit lines 21 are conductive pathways that may connect the memory cells 15 to sense amplifiers, enabling data read and write operations.

FIG. 2 shows two possible configurations, namely, FIG. 2(a) shows a merge bit line configuration in which a bit line 21 is shared with two transistor structures 22, and FIG. 2(b) shows a split bit line configuration in which the bit line 21 addressing is on one transistor structure 22. Each word line 16 is connected to the gates of transistor structures 22 of memory cells 15 (in the circuit schematic at least, in fact, the gates of the transistor structures 22 are even formed by the integral metal structures 16 which are the word lines, as explained before). The addressing of the plate lines 24 and the bit lines 21 can be in a manner top-bottom (or vice versa), top-top, or bottom-bottom, wherein top and bottom relatively relates to the 3D arrangement of memory cells 15 along the first axis.

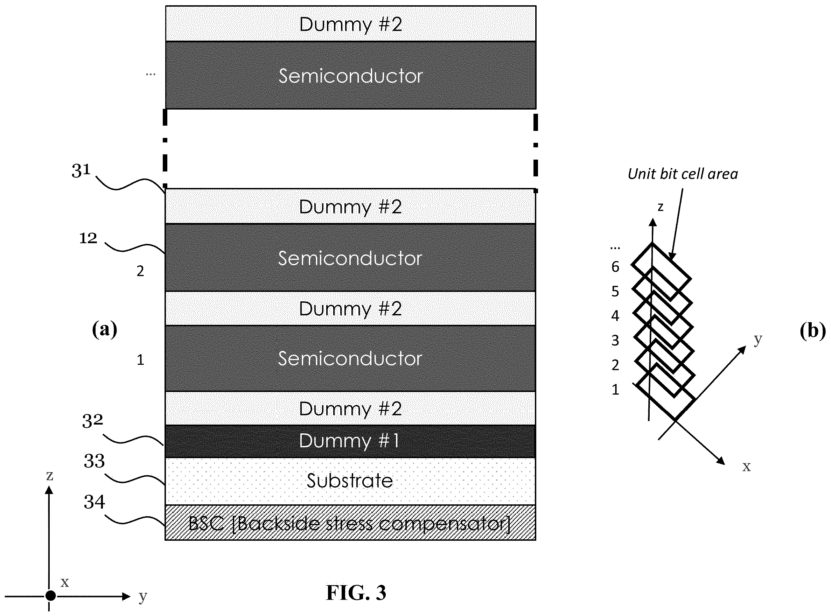

FIG. 3-22 shows exemplary steps for processing a semiconductor structure 10 according to this disclosure, for instance, the semiconductor structure of FIG. 1 or FIG. 2. The figures will be described step-by-step in the following.

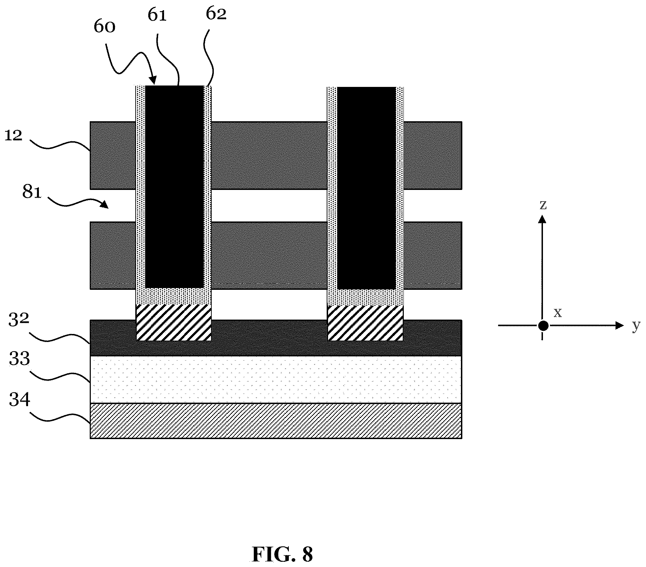

FIG. 3(a) illustrates an initial stack, which can be deposited or grown. The initial stack comprises a substrate 33, a backside stress comparator (BSC) 34 for correcting cumulative stress induced by top layers deposited or grown, an initial dummy layer (Dummy #1), which maybe made of a dielectric material and/or may be used as a template and/or stress relaxation buffer (SRB), and a plurality of alternating semiconductor layers 12 (SEMICONDUCTOR) and dummy layers 31 (Dummy #2). Each semiconductor layer 12 of the stack corresponds later to one unit bit cell area of a particular pillar 14 of memory cells, as schematically indicated in FIG. 3(b). Notably, the BSC can be kept in the stack or removed later, or even redeposited later if removed, based on the evolution of stress during subsequent process steps. The semiconductor layers 12 maybe silicon or silicon-based, but also other semiconductor materials are thinkable. The dummy layers may be silicon germanium, but other suitable dummy layers are possible, i.e., suitable for later removal that is selective with respect to the semiconductor layers (see description of FIG. 8). The shown stack could be structured into a staircase (e.g. one staircase step per each semiconductor layer 12) for a later staircase arrangement of the word lines 16. However, this can be done later in the process as well.

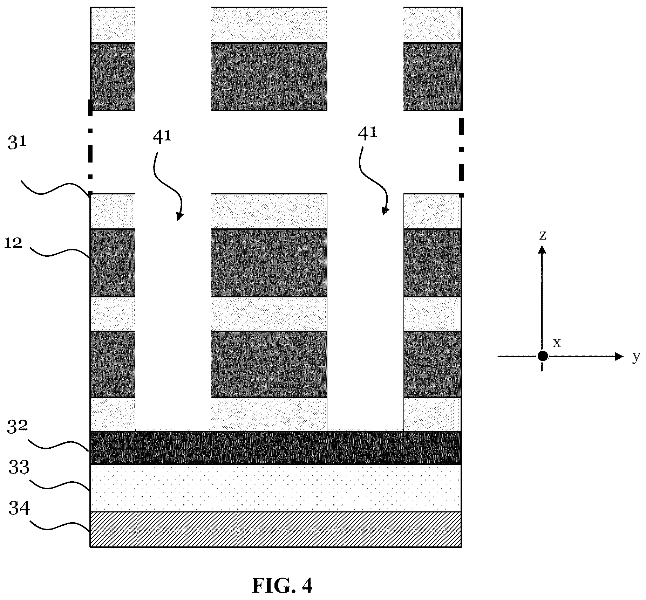

FIG. 4 shows a step intended for bit line and plate line dummy formation, in particular, a step of patterning holes 41 (or cavity or opening). These holes 41 may be regular, and may have a symmetrical shape (in a top-view) or not. For example, they can be square shaped or rectangular. Each hole 41 is either for forming a bit line dummy or a plate line dummy (to be replaced later by bit line 21 and plate line 24, respectively), wherein memory cells will be formed between a pair of plate line and bit line dummy holes 41, i.e., in FIG. 4 between the two shown holes 41.

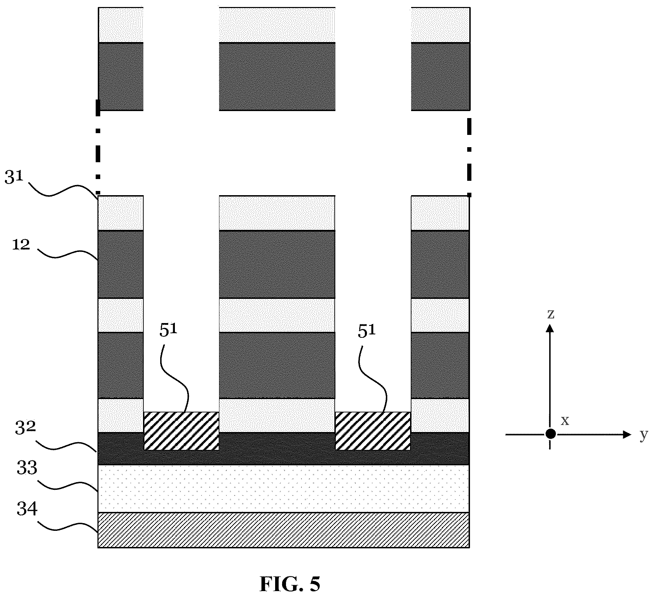

FIG. 5 shows a step of forming a bottom isolation 51 in each hole 41. The formation of the bottom isolation 51 maybe done via: (1) dielectric fill, planarization, and etch back, wherein a protective layer may be considered on the side wall of the hole 41; or (2) by selective deposition.

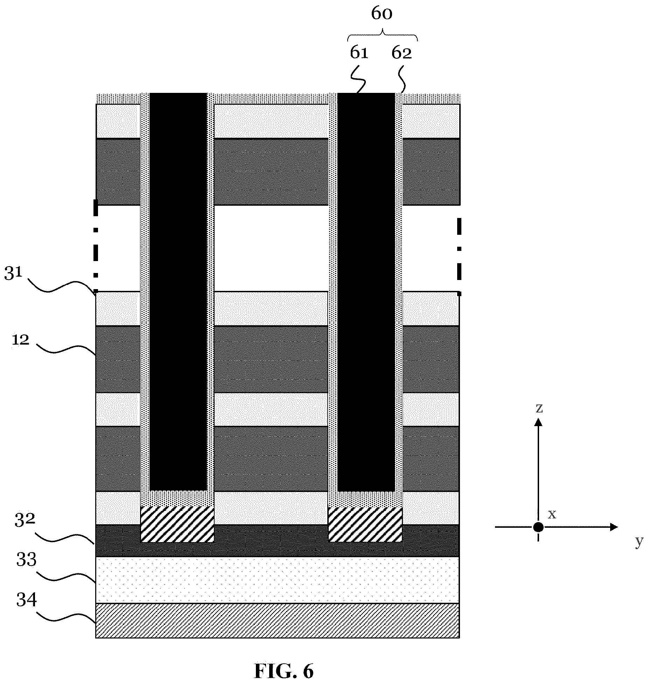

FIG. 6 shows a further a step of the actual dummy formation. Each dummy 60 (bit line dummy and plate line dummy can be identical) comprises an optional liner 62 and a blocking layer 61, which can be subsequently filled into the holes 41. The blocking layer 61 enables sequential processing steps of bit line 21 and plate line 24 independently in a later step. Notably, depending on the nature, e.g. material, of the dummy layers 31, the liner 62 may not be necessary in some case.

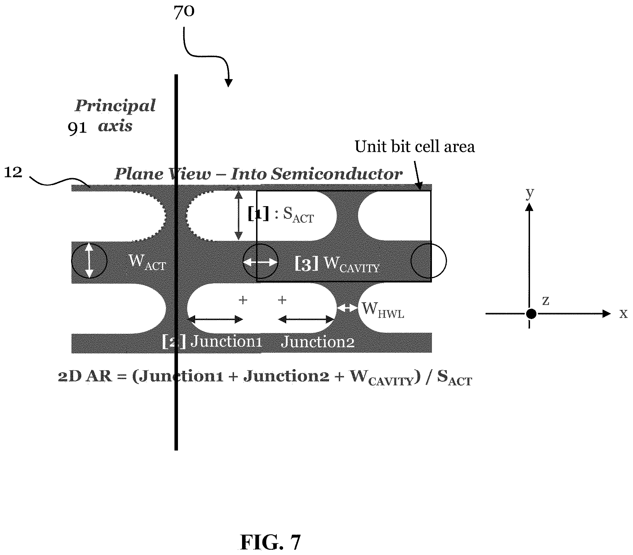

FIG. 7 shows a step of grid formation, i.e., of patterning of the (initial) stack of the semiconductor layers 12 and dummy layers, when viewed from above along the first axis, into a certain shape 70. The grid patterning can be done with a bidirectional mask (x- and y-axis). Different design sizes are possible, in order to have sufficient capacitor or gate extension lengths, for instance. For instance, different dimensions for "Junction", "W_{CAVITY}" or S_{ACT}", as indicated in FIG. 7, are possible. The certain shape 70 may facilitate a later performed semiconductor layer cut. The certain shape 70 may comprise one or more principal axis (running vertically in FIG. 8), and attached elements (running horizontally). The grid patterning may be carried out using single or dual exposure, and/or extreme ultraviolet (EUV), and/or directional etching.

FIG. 8 shows a step of laterally removing the dummy layers 31 (Dummy #2), in order to release the semiconductor layers 12. This forms recesses 81 between the semiconductor layers 12. This step maybe done by selective etching of the dummy layer material, e.g., selective etching of silicon germanium.

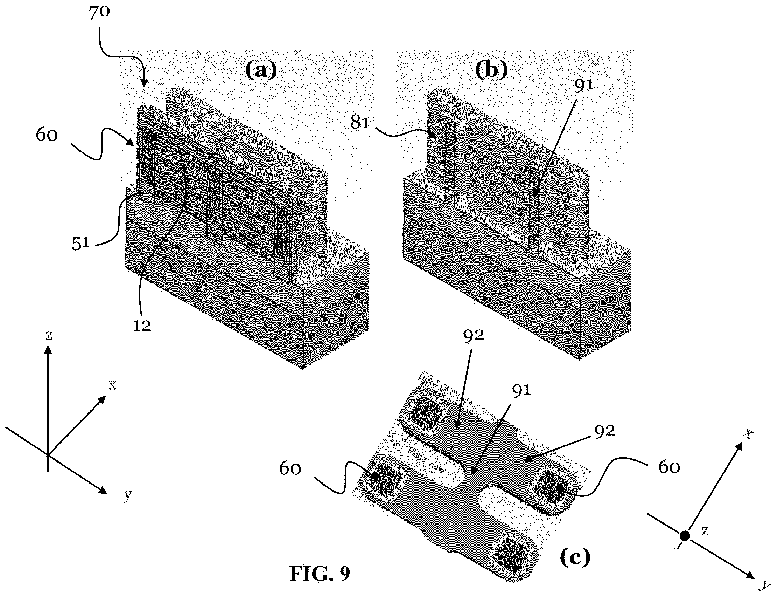

FIG. 9 shows perspective 3D views of the resulting intermediate structures after the step of FIG. 8. In particular, FIG. 9(c) shows the certain shape 70 of the stack in a top view, FIG. 9(a) shows a perspective view of the part of the stack having that shape 70 (it maybe repeated multiple times across the stack as derivable form FIG. 7), and FIG. 9(b) shows only one part of the symmetric structure of the shape 70 for better view. It can be seen that the shape 70 comprises the principal axis 91 and the symmetrically (or asymmetrically regarding the principal axis) attached elements 92, which extends away from the principal axis 91 on both sides of the principal axis 91. FIG. 9(b) shows half the stack of FIG. 9(a), which allows viewing the principal axis 91 in cross section. The dummy BLs/PLs 60 can be seen, also in a top view.

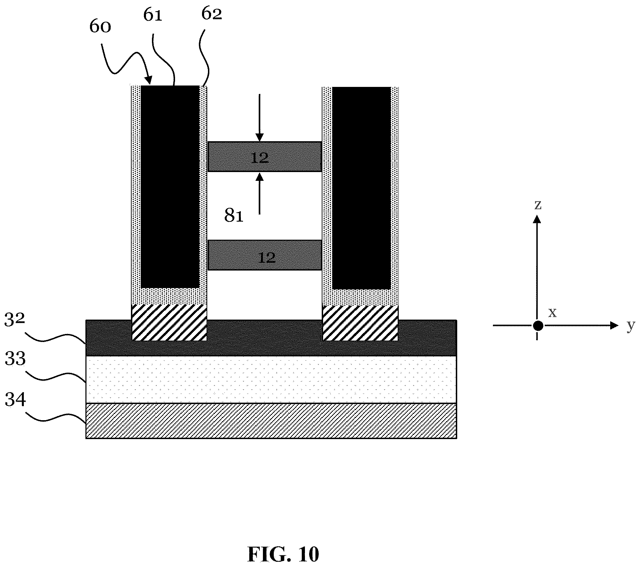

FIG. 10 shows a step of thinning the semiconductor layers 12. The thinning may be combined with cutting the semiconductor layer 12 between at positions, which will be between adjacent memory cells 15 associated with the same integral metal structure 16. This is done to separate the channels of the transistor structures 22 with metal gates formed by the same integral metal structure 16. The thinning may, however, be done separately from, i.e., not combined with this adjacent memory cell cut. The cut is irrespective of a thinning requirement.

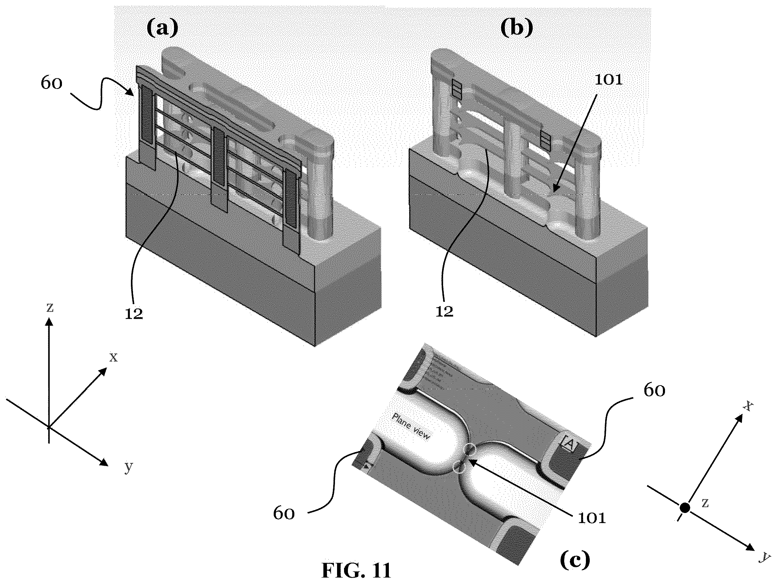

FIG. 11 shows, in a similar manner as FIG. 9 the perspective and top views of the resulting intermediate structure, after the thinning and cutting step of FIG. 10. It can be seen that the semiconductor layers 12 are much thinner, and that the principal axis 91 is cut (see FIG. 11(b) and (c)), whereby a gap 101 is created.

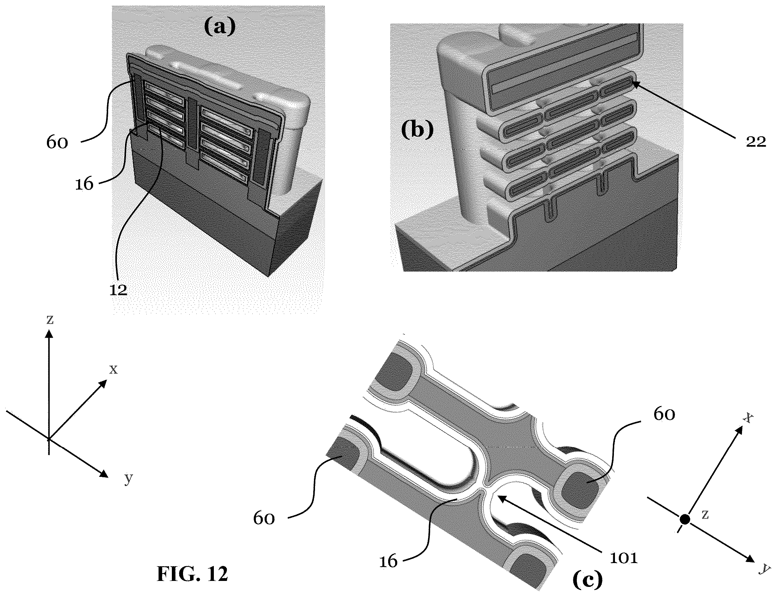

FIG. 12 illustrates perspective views in a similar manner as FIG. 11, illustrating a word line formation, i.e., the formation of the integral metal structures 16. In particular, this maybe done in a step of gate stack deposition. The step may include a sequence of depositing a gate oxide, a work-function metal and metal material for the metal gates forming the integral metal structures 16. The sequence leads to the formation of GAA transistors structures 22, i.e., each transistor channel is at least partly surrounded by an integral metal structure 16. It can be seen in FIG. 12(b) and (c) that the metal structure 16 fills the gap 101, i.e. becomes integral along the x-axis. CMP may also be done, and the staircase arrangement of the integral metal structures 16 can be implemented at this step. The word line formation may also be activated using a replacement gate methodology.

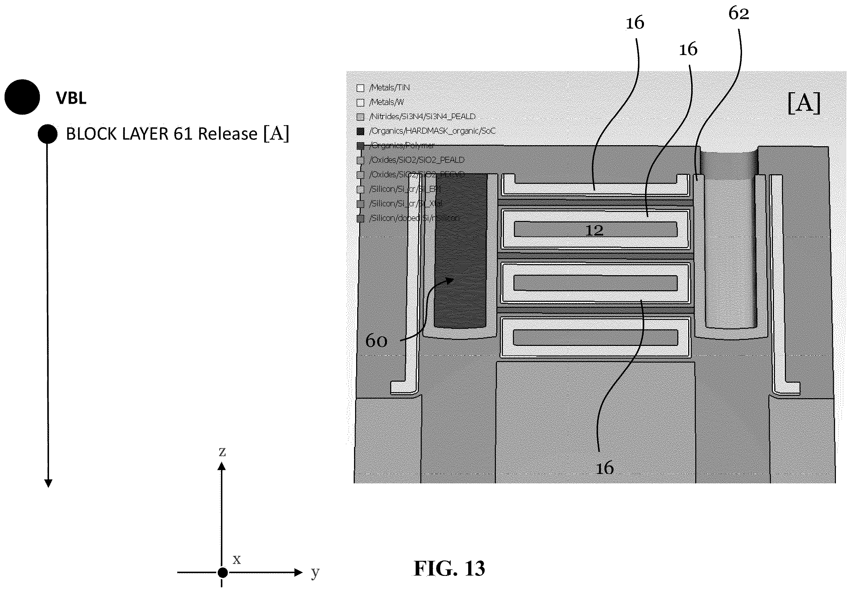

FIG. 13-18 illustrates steps for the formation of the vertical bit lines 21 and the formation of the capacitors 23 and plate lines 24. On the respective left sides of the figures, a detailed exemplary process flow is provided.

In FIG. 13, the blocking layer 61 of one of the dummy 60 is released. In particular, the dummy 60 on the right side, which will be substituted by a vertical bit line 21 (VBL).

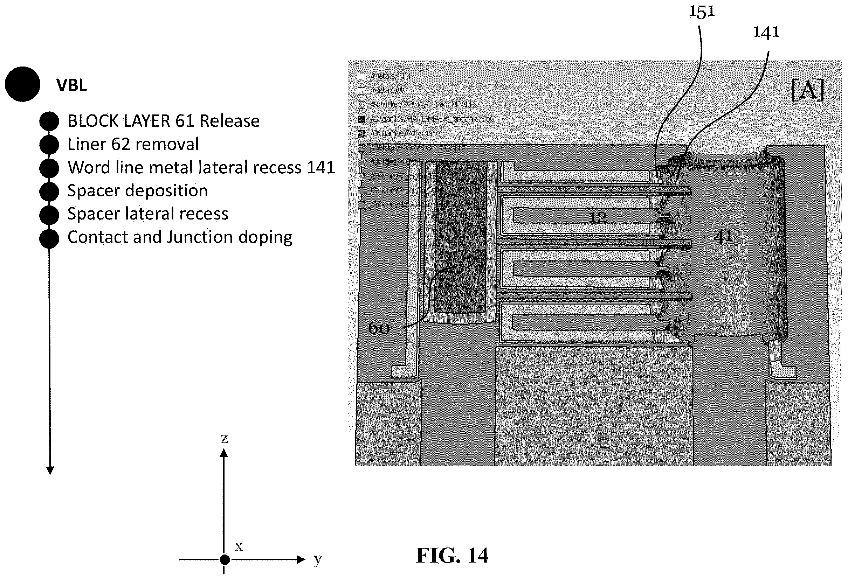

In FIG. 14, the liner 61 is also removed, and lateral recesses 141 are formed into the word lines 16 from the right. The hole/opening 41 is thereby reopened. The lateral recesses may insure a word line cut, isolating bottom word line of the top transistor from the top gate of the bottom transistor.

Further in FIG. 14, a spacer layer 151, e.g. silicon nitride or an alternative low K material, is deposited into the lateral recesses 141. Prior to bit line metallization a doping of the contact and junction may be necessary. This doping may be done by at least one of PSG (), liquid doping, GPD (Gas phase doping), and epitaxy.

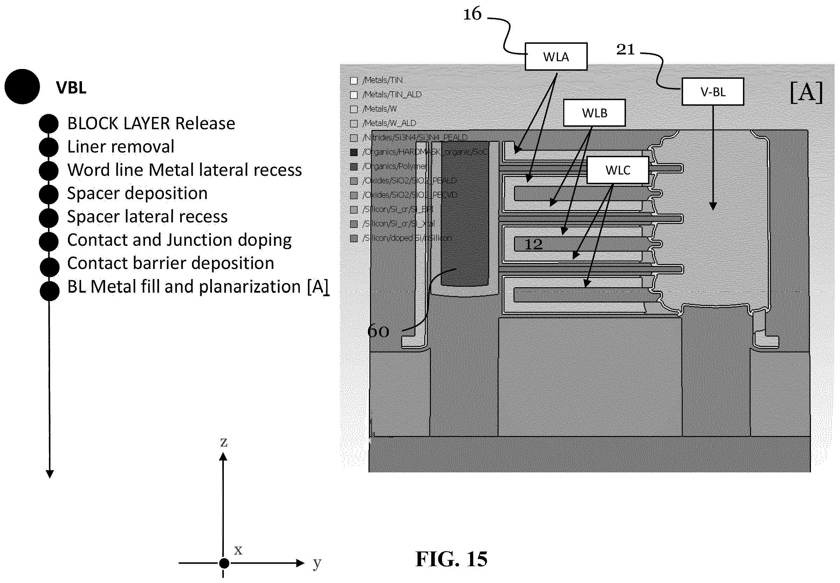

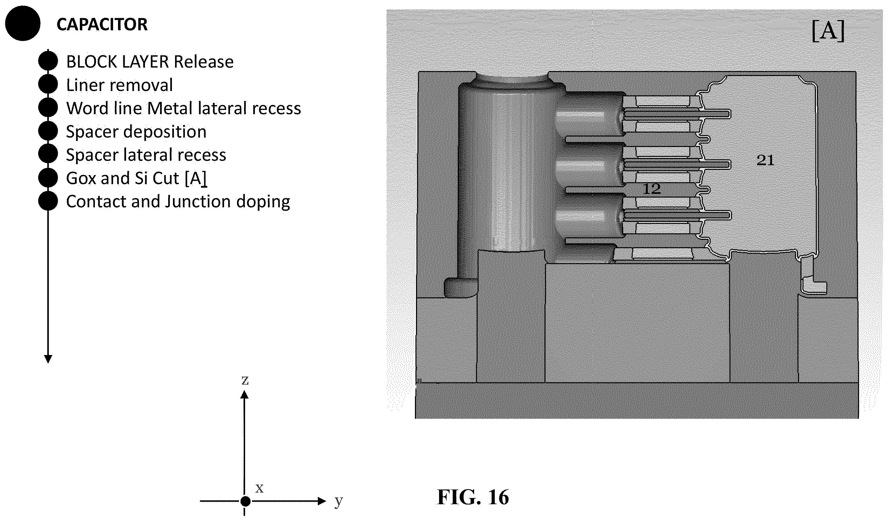

In FIG. 15, the vertical bit line 21 is formed, for example, by deposition of the barrier metal (e.g. Mo, Ti, TiN, Co) and the metal fill (e.g. W, Mo, Co) into the reopened hole 41. In FIG. 16, the stacked integral metal structures 16 which will act as word lines WLA, WLB, WLC, are indicated.

In FIG. 16, the blocking layer 62 of the other dummy 60 is removed. In particular, the dummy 60 on the left side which will be substituted by a capacitor 23 and plate line 24.

Further in FIG. 16, the liner 61 of the other dummy 60 is also removed, and lateral recesses (not visible) are formed into the word lines 16 from the left. The hole/opening is thereby reopened.

Further, a spacer layer, e.g. silicon nitride, is deposited into the lateral recesses (not visible). For instance, silicon nitride and/or low K material.

Further, a gate dielectric opening is formed and a part of the semiconductor layer 12 is cut, in preparation for forming the capacitor structures 23. Prior to bit line metallization a doping of the contact and junction may be necessary. This doping may be done by at least one of PSG (), liquid doping, GPD (Gas phase doping), and epitaxy.

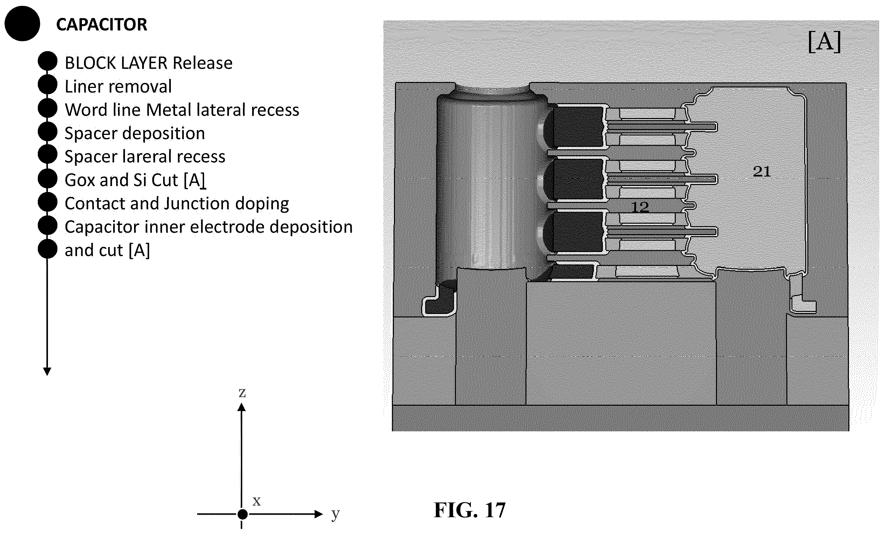

In FIG. 17, the capacitor structures are started to be formed, which involves metal deposition for the capacitor electrodes, for instance titanium nitride, with can be done by atomic layer deposition. Prior to the capacitor electrode, a barrier may be necessary, for instance implemented as one or more of Mo, Ti, TiN, Co.

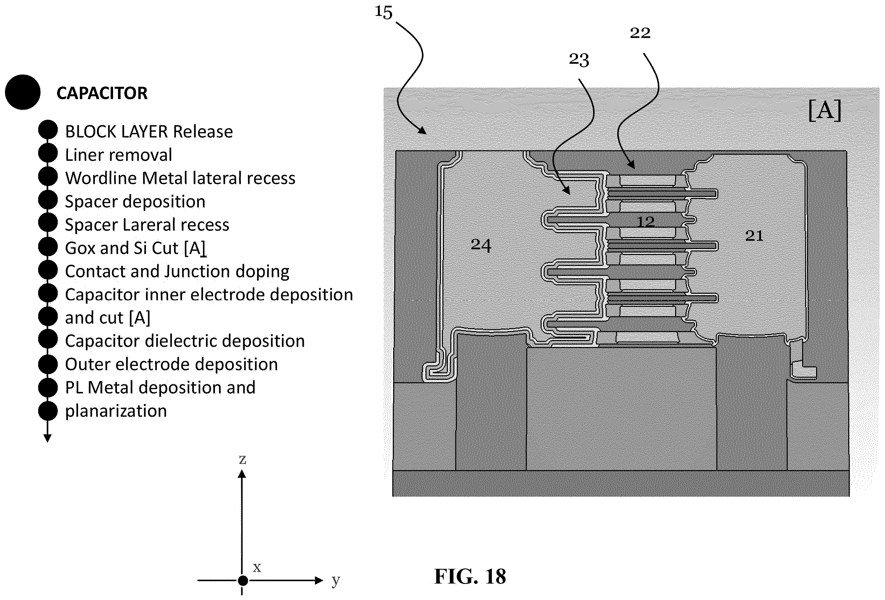

In FIG. 18, the capacitor structures 23 are completed and the plate line 24 connecting to the capacitor structures 23 is formed. This involves deposition of ZAZ (ZrO₂. Al₂o₃. ZrO₂), SCO, and/or ferroelectric material for the capacitor dielectric and titanium nitride for the plate line 24.

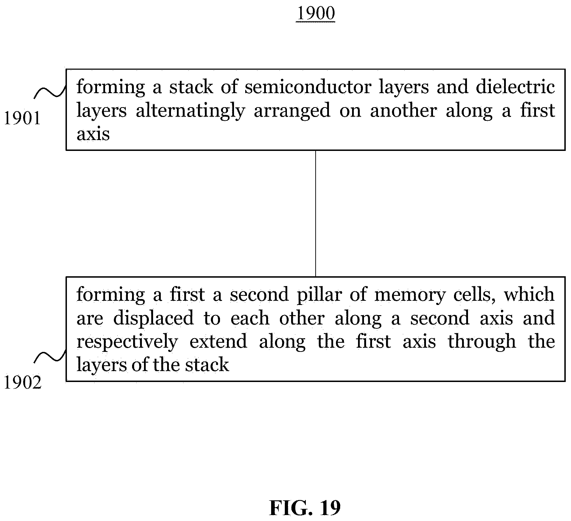

FIG. 19 shows a flow diagram of a general method 1900 of fabricating the semiconductor structure 10. The method comprises a step 1901 of forming a stack 11, which comprises a plurality of semiconductor layers 12 and dielectric layers 13, which are alternatingly arranged on another along a first axis. The method 1900 further comprises a step 1902 of forming a first pillar 14a of memory cells 15 and a second pillar 14b of memory cells 15. As already described before, the first and second pillar 14a, 14b are formed displaced to each other along a second axis, which is perpendicular to the first axis, and respectively extend along the first axis through the layers of the stack 11. Each memory cell 15 is formed from a part of one of the semiconductor layers 12. For each memory cell 15 one transistor structure 22 and one capacitor structure 23 is formed. Each transistor structure 22 comprises a semiconductor channel and a metal gate that is formed to at least partly surround the semiconductor channel. The metal gates of memory cells 15 in the same pillar 14a, 14b are isolated from each other. The metal gates of memory cells 15 of the first and second pillar 14a, 14b that are formed from parts of the same semiconductor layer 12 are formed as an integral metal structure 16.

In summary, this disclosure provides a semiconductor structure 10 that can be used, for instance, as a building block or a unit cell, for producing a 3D DRAM with a 1T1C cell configuration. The semiconductor structure 10 provides vertical bit lines 21 and horizontal word lines comprising the integral metal structures 16. The disclosure also provides a process and method to fabricate the semiconductor structure 10. The process uses stack shaping, semiconductor layer cutting and thinning, and integral formation of metal gates to form the semiconductor structure 10 in a low complex and cost efficient manner.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A semiconductor structure (10) for a three-dimensional, 3D, dynamic random access memory, DRAM, the semiconductor structure (10) comprising:
a stack (11) comprising a plurality of semiconductor layers (12) and dielectric layers (13), which are alternatingly arranged on another along a first axis (z);
a first pillar (14a) of memory cells (15) and a second pillar (14b) of memory cells (15),
wherein the first and second pillar (14a, 14b) are arranged displaced to each other along a second axis (x), which is perpendicular to the first axis (z), and respectively extend along the first axis (z) through the layers of the stack (11);
wherein each memory cell (15) of the first and the second pillar (14a, 14b) comprises a part of one of the semiconductor layers (12);
wherein each memory cell (15) of the first and the second pillar (14a, 14b) comprises one transistor structure (22) and one capacitor structure (23);
wherein each transistor structure (22) comprises a semiconductor channel and a metal gate that at least partly surrounds the semiconductor channel;
wherein the metal gates of memory cells (15) in the same pillar are isolated from each other; and
wherein the metal gates of memory cells (15) of the first and second pillar (14,a, 14b) that comprise parts of the same semiconductor layer (12) form an integral metal structure (16).

2. The semiconductor structure (10) according to claim 1, wherein
each integral metal structure (16) is a word line and/or is connected to at least one word line driver.

3. The semiconductor structure (10) according to claim 1 or 2, wherein
in each memory cell (15), the transistor structure (22) and the capacitor structure (23) are formed next to each other along a third axis (y), which is perpendicular to the first axis (z) and the second axis (x).

4. The semiconductor structure (10) according to one of the claims 1 to 3, further comprising:
a plurality of bit lines (21);
wherein each bit line (21) extends along the first axis (z) and is connected to all the memory cells (15) of one pillar (14a, 14b).

5. The semiconductor structure (10) according one of the claims 1 to 4, further comprising:
one or more additional pillars of memory cells (15) arranged one after the other along the second axis (x) and in-line with the first and second pillar (14a, 14b) and respectively extending through the layers of the stack (11);
wherein the integral metal structures (16) are stacked along the first axis (z), and each integral metal structure (16) is associated with two or more of the pillars (14a, 14b) arranged along the second axis.

6. The semiconductor structure (10) according to claim 5, wherein
each integral metal structure (16a) is associated with more of the pillars (14a, 14b) than the integral metal structure (16) arranged above it.

7. The semiconductor structure (10) according to claim 5 or 6, wherein
the integral metal structures (16) are stacked in a staircase arrangement.

8. The semiconductor structure (10) according to one of the claims 1 to 7, further comprising:
a third pillar of memory cells and a fourth pillar of memory cells;
wherein the third and fourth pillar are arranged displaced to each other along the second axis (x), respectively extend through the layers of the stack (11), and are respectively arranged displaced from the first and second pillar along a third axis (y), which is perpendicular to the first and second axis (z, x);
wherein each memory cell (15) of the third and fourth pillar comprises one of the semiconductor layers (12);
wherein each memory cell (15) of the third and fourth pillar comprises one transistor structure (22) and one capacitor structure (23); and
wherein the metal gates of the memory cells (15) of the third and fourth pillar that comprise parts of the same semiconductor layer (12) form a second integral metal structure (16), which is isolated from the integral metal structure formed by the metal gates of the memory cells (15) of the first and second pillar (14a, 14b) that comprise parts of the same semiconductor layer (12).

9. The semiconductor structure (10) according to one of the claims 1 to 8, wherein
a shape (70) of the stack of semiconductor layers (12) and dielectric layers (13), when viewed from above along the first axis (z), comprises a principal axis (91) and symmetrically or asymmetrically attached elements (92) extending away from the principal axis on both sides of the principal axis (91);
wherein the pillars of memory cells are formed at least partly in the attached elements (92).

10. A method (1900) of fabricating a semiconductor structure (10) for a three-dimensional, 3D, dynamic random access memory, DRAM, the method (2300) comprising:
forming (1901) a stack (11) comprising a plurality of semiconductor layers (12) and dielectric layers (13), which are alternatingly arranged on another along a first axis (z);
forming (1902) a first pillar (14a) of memory cells (15) and a second pillar (14b) of memory cells (15);
wherein the first and second pillar (14a, 14b) are formed displaced to each other along a second axis (x), which is perpendicular to the first axis (z), and respectively extend along the first axis (z) through the layers of the stack (11);
wherein each memory cell (15) is formed from a part of one of the semiconductor layers (12);
wherein for each memory cell (15) one transistor structure (22) and one capacitor structure (23) is formed;
wherein each transistor structure (22) comprises a semiconductor channel and a metal gate that is formed to at least partly surround the semiconductor channel;
wherein the metal gates of memory cells (15) in the same pillar (14a, 14b) are isolated from each other; and
wherein the metal gates of memory cells (15) of the first and second pillar (14a, 14b) that are formed from parts of the same semiconductor layer (12) are formed as an integral metal structure (16).

11. The method (2300) according to claim 10, further comprising:
forming a third pillar of memory cells and a fourth pillar of memory cells;
wherein the third and fourth pillar are formed displaced to each other along the second axis, respectively extend along the first axis through the layers of the stack, and are respectively formed offset from the first and second pillar along a third axis, which is perpendicular to the first and second axis;
wherein each memory cell of the third and fourth pillar is formed from a part of one of the semiconductor layers;
wherein each memory cell of the third and fourth pillar comprises one transistor structure and one capacitor structure;
wherein the metal gates of memory cells of the third and fourth pillar that are formed from parts of the same semiconductor layer are formed by a second integral metal structure, which is isolated from the integral metal structure formed by the metal gates of memory cells of the first and second pillar that are formed form parts of the same semiconductor layer.

12. The method (2300) according to claim 10 and 11, wherein for forming the stack (11) and the pillars (14a, 14b) of memory cells (15) in the stack (11), the method (2300) comprises:
growing and/or depositing a stack comprising a plurality of semiconductor layers (12) and dummy layers (31), which are alternatingly arranged on another along the first axis (z), wherein the semiconductor layers (12) are respectively thicker than the dummy layers (31);
forming a cavity (41) for each memory pillar, each cavity (41) extending along the first axis through the layers of the stack;
removing the dummy layers (31); and
forming the memory cells (15) from the semiconductor layers (12) through the cavities.

13. The method (2300) according to claim 12, wherein after forming the cavities (41) and before removing the dummy layers (31), the method (2300) further comprises
shaping the stack of semiconductor layers and dummy layers, when viewed from above along the first axis, into a shape (70) comprising a principal axis (91) and symmetrically or asymmetrically attached elements (92) extending away from the principal axis (91) on both sides of the principal axis (91); and
wherein the cavities (41) are formed in the attached elements (92).

14. The method (2300) according to claim 13, wherein after removing the dummy layers (31) and before forming the memory cells (15), the method (2300) further comprises
separating the principal axis (91) of the shape (70) of the stack between a pair of the attached elements (92), wherein the separating optionally includes thinning the semiconductor layers (12);
depositing gate dielectric to surround each semiconductor channel; and forming the metal gates by direct material deposition or material replacement.
